# EUROPÄISCHE PATENTSCHRIFT

(11) **EP 0 970 509 B1**
(45) Veröffentlichungstag und Bekanntmachung des Hinweises auf die Patenterteilung: **10.12.2003**
(21) Anmeldenummer: 98910672.9
(22) Anmeldetag: 14.02.1998
(51) Int. Cl.: H01L 21/00

(54) **VORRICHTUNG UND VERFAHREN ZUM BEHANDELN VON SUBSTRATEN IN EINEM FLUID-BEHÄLTER**
PROCESS AND DEVICE FOR TREATING SUBSTRATES IN A FLUID CONTAINER
PROCEDE ET DISPOSITIF POUR TRAITER DES SUBSTRATS DANS UN RECIPIENT DE FLUIDE

(30) Priorität: 17.02.1997 DE 19706072
(43) Veröffentlichungstag der Anmeldung: 12.01.2000
(73) Patentinhaber: STEAG MicroTech GmbH, 72124 Pliezhausen (DE)
(72) Erfinder: WEBER, Martin, D-78073 Bad Dürrheim (DE)
(74) Vertreter: Wagner, Karl H., Dipl.-Ing.
(86) Internationale Anmeldenummer: EP9800853
(87) Internationale Veröffentlichungsnummer: WO98036443

(56) Entgegenhaltungen:
- EP-A- 0 658 923
- PATENT ABSTRACTS OF JAPAN vol. 10, no. 306 (E-446), 17.Oktober 1986 & JP 61 121337 A (MATSUSHITA ELECTRIC IND CO LTD), 9.Juni 1986,

## Beschreibung

Die Erfindung betrifft eine Vorrichtung zum Behandeln von Substraten, mit einem Fluid-Behälter und zwei miteinander verbundenen über den Fluid-Behälter bringbaren Substrat-Transporteinrichtungen, die wenigstens eine Substrat-Halteeinrichtung aufweisen, welche die Substrate in einer ersten Stellung halten und in einer zweiten freigeben. Die Erfindung betrifft weiterhin Verfahren zum Bahandeln von Substraten unter Verwendung der erfindungsgemäßen Vorrichtung.

Eine Vorrichtung der eingangs genannten Art ist aus der DE 44 13 077 A derselben Anmelderin bekannt. Das Einsetzen der zu behandelnden Substrate in die Substrat-Transporteinrichtung und das Herausnehmen der behandelten Substrate aus der Substrat-Transporteinrichung ist bei dieser bekannten Vorrichtung sowohl verfahrens- als insbesondere auch im Hinblick auf den erforderlichen Zeitaufwand umständlich, so daß die Produktiviät der bekannten Vorrichtung begrenzt ist.

Aus der DE 195 46 990 A ist eine auf dieselbe Anmelderin zurückgehende Anlage zur chemischen Naßbehandlung von Substraten bekannt, die mit einem ersten, sich in vertikaler Richtung bewegenden Transportschlitten anheb- und absenkbar sind. Ein zweiter Transportschlitten für einen die Substrate enthaltenden Carrier ist vorgesehen, der sich relativ zum ersten, die Substrate bewegenden Transportschlitten bewegen kann. Die Führung und das Ein- und Ausführen der Substrate in den und aus dem Fluidbehälter ohne Carrier ist nicht Gegenstand dieser bekannten Vorrichtung.

Die EP 0 385 536 A zeigt und beschreibt eine Vorrichtung zum Einsetzen und Herausheben von Substraten in einen bzw. aus einem Carrier, der sich in einem Fluid-Behälter befindet. Der Carrier selbst wird dann nach Herausheben der Substrate aus dem Fluid-Behälter ebenfalls herausgehoben.

Aus der DE 44 25 208 A ist eine Einrichtung zur Kopplung von Be- und Entladegeräten mit Halbleiterbearbeitungsmaschinen bekannt, bei der innerhalb einer fahrbaren Einhausung ein justierbares Aufnahmeelement für die Be- und Entladeeinrichtung vorgesehen ist, das zwischen mindestens zwei übereinander liegenden Ebenen verstellbar ist, wobei die Einhausung Ausricht- und Halteelemente zur Befestigung an einem zur Halbleiterbearbeitungsmaschine ausgerichteten Ankoppelelement aufweist.

Die US 4 840 530 zeigt eine Vorrichtung zum Transportieren von Halbleitersubstraten aus einem zu einer Substratbehandlungsanlage gehörenden Substratträger in einen für den weiteren Transport vorgesehenen Carrier und umgekehrt.

Aus der Druckschrift "Patent Abstracts of Japan, vol. 10, No. 306(E446), 17. Oktober 1986 & JP-A-61 121337" ist ein Karussell-Handhabungsgerät für Wafer bekannt, bei dem in den einzelnen Positionen des Karussells jeweils ein Wafer zu verschiedenen Behandlungsbädern bzw. Fluidbehältern durch eine Karussell-Drehbewegung schrittweise gebracht wird. Diese Vorrichtung weist die Merkmale des Oberbegriffs des Anspruchs 1 der vorliegenden Anmeldung auf.

Der Erfindung liegt die Aufgabe zugrunde, eine Vorrichtung zu schaffen und ein Verfahren anzugeben, mit der bzw. mit dem die Behandlung von Substraten in einem Fluid-Behälter und das Be- und Entläden des Fluid-Behälters durch einfache konstruktive Vorrichtungen und insbesondere mit geringem Zeitaufwand sicher und zuverlässig möglich ist, sodaß die Produktivität einer solchen Anlage verbessert werden kann.

Die gestellte Aufgabe wird erfindungsgemäß durch die kennzeichnenden Merkmale des Anspruch 1 gelöst. Mit einer zweiten Substrat-Transporteinrichtung ist es mögliche, den Substratwechsel im Fluid-Behälter wesentlich zu beschleunigen, indem während der Behandlung eines Substratpaketes bereits eine zweite Substrat-Transporteinrichtung mit Substraten bzw. mit einem weiteren zu behandelnden Substratpaket beladen wird. Eine derartige doppelte Substrat-Transporteinrichtung ist insbesondere auch konstruktionsmäßig einfach, so daß der zusätzliche Aufwand für die zweite Substrat-Transporteinrichtung im Hinblick auf die wesentlich höhere Produktivitätsrate gering ist. Da durch eine zweite Substrat-Transporteinrichtung das Be- und Entladen der Substrat-Transporteinrichtung getrennt und entfernt vom eigentlichen Behandlungsort erfolgen kann, ist auch die Transportsicherheit höher, so daß geringere Ausschußraten erreicht werden können.

Sehr vorteilhaft ist es, wenn die beiden Substrat-Transporteinrichtungen, die starr miteinander verbunden sind, eine gemeinsame Einrichtung zum gleichzeitigen Bewegen der Transporteinrichtungen aufweist. Die mechanischen Betätigungsvorrichtungen zum Bewegen der Substrat-Transporteinrichtungen sind daher nicht aufwendiger als bei nur einer Substrat-Transporteinrichtung.

Gemäß einer besonders vorteilhaften Ausführungsform der Erfindung ist wenigstens eine Lade- und/oder Entladestation zum Be- und/oder Entladen der Transporteinrichtung vorgesehen, wobei es besonders vorteilhaft ist, wenn zu beiden Seiten des Fluid-Behälters je eine Lade- und/oder Entladestation vorhanden ist.

Die wenigstens eine Lade- und/oder Entladestation weist vorzugsweise eine Einrichtung zum Trocken eines Substrat-Trägers auf, aus dem die Substrate in die Transporteinrichtung gebracht, oder in die die Substrate aus der Transporteinrichtung eingesetzt werden. Auf diese Weise ist es möglich, die Substrat-Träger nach Herausnehmen nasser oder feuchter Substrate nach dem Trocknungsvorgang direkt wieder für die Aufnahme der behandelten, trockenen Substrate zu verwenden.

Gemäß einer besonders vorteilhaften Ausführungsform der Erfindung weisen die Substrat-Halteeinrichtungen der Substrat-Transporteinrichtungen wenigstens eine drehbare Haltestange auf, die je nach der Drehlage der Haltestange die Substrate in der Substrat-Transporteinrichtung hält oder freigibt. Diese Ausführungsform der Substrat-Transporteinrichtung und Substrat-Halteeinrichtung ist in der nicht vorveröffentlichten DE-A-196 52 526 im einzelnen beschrieben.

Erfindungsgemäß sind die Transporteinrichtungen jeweils in Form von Hauben ausgebildet sind, wobei vorzugsweise zwei gegenüberliegende Wände der Haube Schlitze für die Substrate aufweisen, in denen die Substrate in ihrer Lage und parallel zueinander gehalten werden, wenn sie in die Haube geschoben, aus der Haube entfernt und/oder in der Haube verriegelt sind. Die Haube ist dabei vorzugsweise eine Prozeßhaube, die Einlaßöffnungen für wenigstens ein Fluid aufweist, um einen Trocknüngsprozeß nach dem Marangoni-Verfahren durchführen zu können. Um insofern Wiederholungen zu vermeiden, wird auf die nicht vorveröffentlichten DE-A-195 46 990, DE-A-197 03 646 oder die DE-A-196 37 875 derselben Anmelderin verwiesen.

Die gestellte Aufgabe wird auch durch ein Verfahren zum Behandeln von Substraten in einem Fluid-Behälter mit einer ersten Substrat-Transporteinrichtung und einer zweiten Substrat-Transporteinrichtung nach einem der Ansprüche 1-10 dadurch gelöst, daß die Substrate der sich über den Fluid-Behälter befindenden Substrat-Transporteinrichtung behandelt werden, während die andere Substrat-Transporteinrichtung von Substraten entladen und/oder mit Substraten beladen wird. Während des Behandlungsvorgangs der Substrate ist es also mit dem erfindungsgemäßen Verfahren und der erfindungsgemäßen Vorrichtung möglich, gleichzeitig die andere Substrat-Transporteinrichtung der erfindungsgemäßen Doppel-Transporteinrichtung zu be- und/oder zu entladen. Dadurch wird der gesamte Vorgang wesentlich beschleunigt und die Produktivität der gesamten Anlage gegenüber herkömmlichen Einrichtungen wesentlich verbessert. Da der Be- und Entladevorgang bei der vorliegenden Erfindung im Gegensatz zu herkömmlichen Vorrichtungen nicht über dem Fluid-Behälter, sondern entfernt davon durchgeführt wird, ist es auch möglich, die Vorrichtung selbst einfacher zu gestalten und den Be- und Entladevorgang sicherer und zuverlässiger durchzuführen, so daß die Ausschußrate gesenkt wird.

Außerdem wird die gestellte Aufgabe durch ein Verfahren gemäß Anspruch 12 gelöst.

Obgleich die erfindungsgemäße Vorrichtung auch mit nur einer, auf einer Seite des Fluid-Behälters angeordneten Be- und Entladevorrichtung mit Vorteil einsetzbar ist, so ist es jedoch besonders vorteilhaft, wenn auf beiden Seiten des Fluid-Behälters jeweils eine Be- und/oder Entladevorrichtung vorgesehen ist. In diesem Falle ist es besonders vorteilhaft, wenn das Verfahren folgende Verfahrensschritte aufweist:
a) Herausheben der Substrate aus dem Fluidbehälter in eine erste Substrat-Transporteinrichtung und gleichzeitig Beladen einer zweiten Transporteinrichtung, die sich über einer Be- und/oder Entladestation befindet. Die Substrate werden dabei in der ersten und zweiten Substrat-Transporteinrichtung gehalten und verriegelt.
b) Bewegen der beiden Substrat-Transporteinrichtungen in eine Stellung, bei der sich die erste Substrat-Transporteinrichtung über einer ersten Be- und/oder Entladestation und die zweite Substrat-Transporteinrichtung über dem Fluid-Behälter befindet. Wenn während des Behandlungsvorgangs die Substrat-Transporteinrichtung, die vorzugsweise in Form einer Prozeßhaube ausgebildet ist, über dem Fluid-Behälter möglichst dicht nach außen abschließen soll, ist es vor dem Bewegen bzw. Verschieben der beiden Substrat-Transporteinrichtungen vorteilhaft, diese etwas anzuheben, um danach erst die Verschiebung vorzunehmen.
c) Gleichzeitiges Entladen der Substrate aus der ersten Substrat-Transporteinrichtung in einen Substrat-Träger, der sich in der ersten Be- und/oder Entladestation befindet, sowie der Substrate aus der zweiten Substrat-Transporteinrichtung in den Fluid-Behälter.
d) Bewegen der beiden Substrat-Transporteinrichtungen in eine Stellung, bei der sich die erste Substrat-Transporteinrichtung über dem Fluid-Behälter und die zweite Substrat-Transporteinrichtung über der zweiten Be- und/oder Entladestation befindet.

Der beschriebene Verfahrensablauf ist beliebig oft wiederholbar und ermöglicht einen schnellen Prozeßablauf mit hoher Produktivität.

Wenn die Substrat-Transporteinrichtungen mit drehbaren Haltestangen für die Substrat-Halteeinrichtungen gemäß der DE-A-196 52 526 ausgebildet ist, ist es vorteilhaft, die Verriegelung während des Verfahrensschritts a) bzw. nach dem Verfahrensschritt a) durch Drehen der Haltestange der ersten und zweiten Transporteinrichtung in die Substrat erhaltende erste Stellung vorzunehmen und das Freigeben der Substrate während des Verfahrenschritts c) bzw. nach diesem Verfahrensschritt durch Drehen der Haltestange der ersten und zweiten Transporteinrichtung in die die Substrate freigebende, zweite Stellung zu bringen.

Gemäß einer weiteren vorteilhaften Ausführungsform der Erfindung werden die Substrate beim Herausheben aus dem Fluidbehälter in die erste Substrat-Transporteinrichtung während des Verfahrensschritts a) getrocknet. Ein solcher Trocknungsvorgang ist beispielsweise in der DE-A-44 13 077 und den zuvor genannten, nicht vorveröffentlichten deutschen Anmeldungen der Anmelderin beschrieben.

Insbesondere dann, wenn das sogenannte Marangoni-Trocknungsverfahren angewendet wird, wird gemäß einer weiteren vorteilhaften Ausführungsform des erfindungsgemäßen Verfahrens während des Heraushebens der Substrate aus dem Fluid-Behälter in die als Haube ausgebildete Transporteinrichtung ein Gas in die Haube eingeleitet.

Gemäß einer weiteren vorteilhaften Ausführungsform des erfindungsgemäßen Verfahrens wird ein Substrat-Träger in der ersten und/oder zweiten Be- und/oder Entladestation nach dem Beladen der ersten und/oder zweiten Transporteinrichtung, wenn sich also keine Substrate im Substrat-Träger befinden, getrocknet. Vorzugsweise wird dazu ein Trocknungsgas auf die Substrat-Träger geblasen.

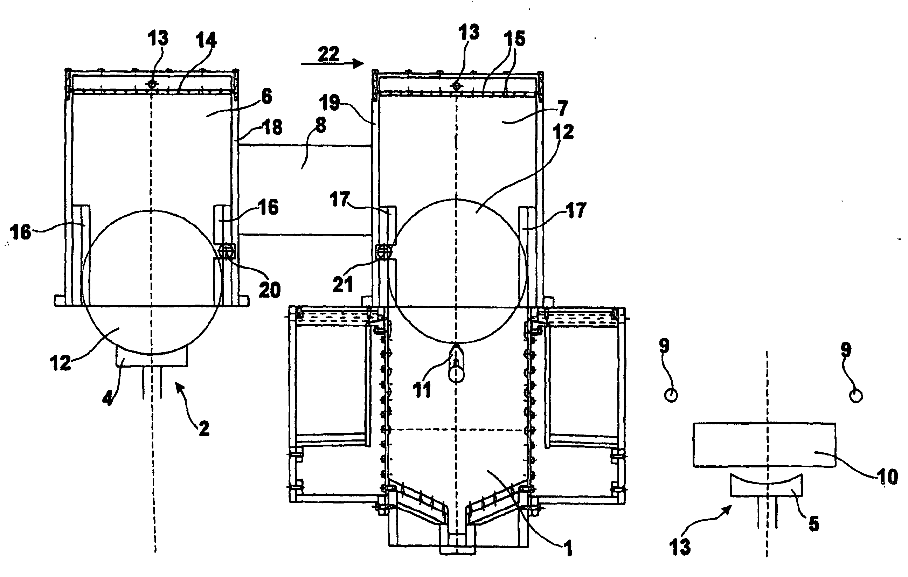

Die Erfindung wird nachfolgend anhand eines bevorzugten Ausführungsbeispiels unter Bezugnahme auf eine einzige Figur erläutert, in der ein Ausführungsbeispiel der erfindungsgemäßen Vorrichtung schematisch und im Querschnitt dargestellt ist.

Die einzige Figur zeigt schematisch einen Fluid-Behälter 1, an dessen einer Seite eine erste Be- und/oder Entladestation 2 und an dessen anderer Seite eine zweite Beund/oder Entladestation 3 mit jeweils einer Substratanheb- bzw. Absenkvorrichtung 4 bzw. 5 schematisch dargestellt ist.

Über der ersten Be- und/oder Entladestation 2 befindet sich eine erste Substrat-Transporteinrichtung 6, und über dem Fluid-Behälter 1 befindet sich eine zweite Substrat-Transporteinrichtung 7, die jeweils als Hauben ausgebildet sind. Die Hauben 6, 7 sind über ein Verbindungselement 8 starr miteinander verbunden.

Die zweite Be- und Entladestation 3 weist zusätzlich eine schematisch angedeutete Substratträger-Trocknungseinrichtung 9 auf, mit der ein Trocknungsgas auf einen ebenfalls schematisch dargestellten Substrat-Träger 10 geblasen wird.

Der Fluid-Behälter 1 weist eine Halterungsvorrichtung 11 in Form einer messerartigen Leiste auf, mit der Substrate 12 in den Fluid-Behälter 1 abgesenkt und aus ihm herausgehoben werden. Beispiele für Ausführungsformen des Fluid-Behälters 1 und der Halterungsvorrichtung 11 sind in der DE-A-44 013 077 oder den zuvor genannten, nicht vorveröffentlichten Anmeldungen derselben Anmelderin beschrieben, so daß darauf Bezug genommen wird, um Wiederholungen zu vermeiden.

Die Hauben 6, 7 sind bei dem dargestellten Ausführungsbeispiel als Prozeßhauben ausgebildet und besitzen daher Einlaßöffnungen 13 und Verteilungsöffnungen 14, 15, über die ein Behandlungsgas, beispielsweise ein Gemisch aus Stickstoff und Isopropylalkohol, ins Innere der Haube 6 bzw. 7 eingelassen wird, um den Trocknungsvorgang beim Herausheben der Substrate 12 aus dem Fluidbehälter 1 gemäß dem Marangoni-Verfahren zu verbessern und zu beschleunigen.

Die Hauben 6, 7 weisen weiterhin Schlitze 16 bzw. 17 in den jeweiligen Seitenwänden auf, in denen die Substrate 12 während des Ein- und Ausbringens geführt sowie in ihrer Lage gehalten werden. In jeweils einer Wand 18 bzw. 19 der Haube 6 bzw. 7 befindet sich jeweils eine Substrat-Halteeinrichtung 20, 21 in Form einer drehbaren Haltestange.

Die als Substrat-Transporteinrichtung eingesetzte Haube 6 bzw. 7 und die als drehbare Haltestange ausgebildete Substrat-Halteeinrichtungen in den Hauben 6 und 7 sowie die Funktionsweise dieser Einrichtungen sind in der nicht vorveröffentlichten DE-A-196 52 526 detailliert beschrieben.

Die Funktion der erfindungsgemäßen Vorrichtung gemäß dem in der einzigen Figur dargestellten Ausführungsbeispiel wird nachfolgend erläutert.

Zu dem in der Figur dargestellten Verfahrenszeitpunkt befinden sich die drehbaren Haltestangen 20, 21 der Hauben 6, 7 in einer zweiten, die Substrate 12 freigebenden Stellung, so daß sie in der ersten Be- und/oder Entladestation 2 mit der Substratanheb- bzw. Absenkvorrichtung 4 aus der Haube 6 bzw. mit der messerartigen Leiste 11 aus der Haube 7 in den Fluid-Behälter 1 abgesenkt werden.

Die aus der Haube 6 entladenen, behandelten bzw. trockenen Substrate 12 werden in einen nicht dargestellten Substrat-Träger unterhalb der Haube 6 abgestellt, um die behandelten Substrate einer weiteren Behandlungsstation oder einem weiteren Verfahrensschritt zuführen zu können.

Nach vollständigem Absenken der Substrate 12 in die erste Be- und Entladestation 2 bzw. in den Fluid-Behälter 1 wird die Doppelhaube 6, 7, 8 in Richtung eines Pfeils 22 so weit verschoben, daß sich die erste Haube 6 über dem Fluid-Behälter 1 und die zweite Haube 7 über der zweiten Be- und Entladestation 3 befindet.

Bevor die Doppelhaube 6, 7, 8 in Richtung des Pfeils 22 verschoben wird, kann sie auch etwas angehoben und nach dem Verschieben wieder abgesenkt werden. Auf diese Weise ist es möglich, den Übergang zwischen Fluid-Behälter 1 und Haube 6 bzw. 7 abzudichten, was gegebenenfalls für den Behandlungsvorgang vorteilhaft ist.

Wenn sich die Haube 6 über dem Fluid-Behälter 1 und damit die Haube 7 über der zweiten Be- und/oder Entladestation 3 befindet, wird die messerartige Leiste 11 im Fluid-Behälter 1 nach oben bewegt, so daß die Substrate 12 in die Schlitze 16 der ersten Haube 6 geschoben werden, bis sie sich über der Haltestange 20 befinden. Während des Anhebens der Substrate aus dem Fluid-Behälter 1 erfolgt ein Trocknungsvorgang, der durch Einleiten eines Gases in die erste Haube 6 unter Anwendung des Marangoni-Verfahrens beschleunigt abläuft. Gleichzeitig mit dem Beladen der ersten Haube 6 über dem Fluid-Behälter 1 wird auch die zweite, sich über der zweiten Be- und/oder Entladestation 3 befindende Haube 7 mit zu behandelnden Substraten 12 beladen, indem die Substratanheb- und/oder Absenkvorrichtung 5 die Substrate 12 aus einem Substrat-Träger 10 heraus anhebt und soweit in die zweite Haube 7 schiebt, daß sie über die drehbare Haltestange 21 gelangen und durch Drehen der Haltestange in die erste, die Substrate haltende Stellung verriegelt werden.

Danach erfolgt das Verschieben der Doppelhaube 6, 7, 8 in Gegenrichtung zum Pfeil 22, so daß sich danach wiederum die erste Haube 6 über der ersten Be- und/oder Entladestation 2 und die zweite Haube 7 sich über dem Fluid-Behälter 1 befindet, wie dies in der Figur gezeigt ist. Sowohl die messerartige Leiste 11 im Fluid-Behälter 1 als auch die Substratanhebe- und/oder Absenkvorrichtung 4 der ersten Be- und/oder Entladestation 2 werden danach in die obere Stellung gefahren. Beim Drehen der Haltestangen 20, 21 in die zweite, die Substrate freigebende Stellung werden die Substrate aus den Hauben 6, 7 abgesenkt und in der ersten Be- und/oder Entladestation 2 in einen nicht dargestellten Substrat-Träger abgestellt bzw. vollständig in das Behandlungsfluid im Fluid-Behälter 1 eingetaucht.

Danach wird die Doppelhaube 6, 7, 8 wieder in der Stellung verfahren, in der sich die erste Haube 6 über dem Fluid-Behälter 1 und die zweite Haube 7 über der zweiten Be- und Entladestation 3 befindet. Der beschriebene Ablauf ist beliebig oft wiederholbar.

Die Erfindung wurde zuvor anhand eines bevorzugten Ausführungsbeispiels beschrieben. Dem Fachmann sind jedoch Abwandlungen, Ausgestaltungen und Modifikationen möglich, ohne daß dadurch der Erfindungsgedanke verlassen wird. Obgleich die Vorrichtung und das Verfahren zuvor am Beispiel eines Trocknungsvorgangs beschrieben wurde, sind die erfindungsgemäße Vorrichtung und die erfindungsgemäßen Verfahren ebenso gut für den Transport der Substrate im Zusammenhang mit anderen Behandlungsvorgängen anwendbar.

## Patentansprüche

1. Vorrichtung zum Behandeln von Substraten (12), mit einem Fluid-Behälter (1) und zwei star mit ein ander verbundenen, über den Fluid-Behälter (1) bringbaren Substrat-Transporteinrichtungen (6 bzw. 7), die wenigstens eine Substrat-Halteeinrichtung (20 bzw. 21) aufweisen, welche die Substrate (12) in einer ersten Stellung halten und in einer zweiten freigeben, **dadurch gekennzeichnet, daß** die zwei Transporteinrichtungen als Haube für mehrere Substrate ausgebildet sind, und daß die Substrat-Transporteinrichtungen (7 bzw. 6) zur abwechselnden Positionierung der Substrat-Transporteinrichtungen (7 bzw. 6) über dem Fluid-Behälter (1) linear bewegbar sind.

2. Vorrichtung nach Anspruch 1, **gekennzeichnet durch** eine gemeinsame Einrichtung zum gleichzeitigen Bewegen der beiden Substrat-Transporteinrichtungen (6, 7).

3. Vorrichtung nach Anspruch 1 oder 2, **gekennzeichnet durch** wenigstens eine Substrat-Lade- und/oder Entladestation (2, 3) zum Be- und/oder Entladen der Transporteinrichtungen (6, 7).

4. Vorrichtung nach Anspruch 3, **dadurch gekennzeichnet, daß** wenigstens eine Ladeund/oder Entladestation (2, 3) eine Einrichtung (9) zum Trocknen eines Substrat-Trägers (10) aufweist.

5. Vorrichtung nach einem der vorhergehenden Ansprüche, **dadurch gekennzeichnet, daß** die Substrat-Halteeinrichtungen (20, 21) wenigstens eine drehbare Haltestange umfassen.

6. Vorrichtung nach Anspruch 5, **dadurch gekennzeichnet, daß** die Haltestangen (20, 21) durch Drehen aus der ersten, die Substrate (12) haltenden Stellung in eine zweite, die Substrate (12) freigebende Stellung bringbar sind.

7. Vorrichtung nach Anspruch 6, **dadurch gekennzeichnet, daß** zwei gegenüberliegende Wände der Hauben (6, 7) Schlitze (16 bzw. 17) für die Substrate (12) aufweisen.

8. Vorrichtung nach einem der Ansprüche 4 bis 7, **dadurch gekennzeichnet, daß** die Haltestangen (20, 21) in dem Längsbereich, an dem die Substrate (12) in der ersten, die Substrate haltenden Stellung anliegen, Schlitze für die Substrate (12) aufweisen.

9. Vorrichtung nach einem der Ansprüche 6 bis 8, **dadurch gekennzeichnet, daß** die Hauben (6, 7) Prozeßhauben mit Einlaßöffnungen (13) für wenigstens ein Fluid sind.

10. Vorrichtung nach einem der Ansprüche 3 bis 9, **dadurch gekennzeichnet, daß** die Lade- und/oder Entladestationen (2, 3) jeweils eine Substratanheb- bzw. Absenkvorrichtung (4 bzw. 5) zum Anheben und/oder Absenken der Substrate (12) in die Transporteinrichtung (6, 7) bzw. aus der Transporteinrichtung (6, 7) aufweisen.

11. Verfahren zum Behandeln von Substraten (12) in einem Fluid-Behälter (1) mit einer Vorrichtung nach einem der vorhergehenden Ansprüche, wobei die Substrate (12) der sich über dem Fluid-Behälter (1) befindenden Substrat-Transporteinrichtung (6 bzw. 7) behandelt werden, während die andere Substrat-Transporteinrichtung (7 bzw. 6) von Substraten (12) entladen und/oder mit Substraten (6, 7) beladen wird.

12. Verfahren zum Behandeln von Substraten (12) in einem Fluid-Behälter (1) und einer Vorrichtung nach einem der Ansprüche 1 bis 10, mit folgenden Verfahrensschritten:
a) Herausheben der Substrate (12) aus dem Fluid-Behälter (1) in eine erste als Haube ausgebildete Substrat-Transporteinrichtung (6) und gleichzeitig Beladen einer zweiten als Haube ausgebildete Substrat-Transporteinrichtung (7), die sich über einer zweiten Be- und/oder Entladestation befindet;
b) lineares Bewegen der beiden Substrat-Transporteinrichtungen (6, 7) in eine Stellung, bei der sich die erste Substrat-Transporteinrichtung über einer ersten Be- und/oder Entladestation, und die zweite Substrat-Transporteinrichtung über dem Fluid-Behälter (19) befindet;
c) Gleichzeitiges Entladen der Substrate aus der ersten Substrat-Transporteinrichtung (6) in einen Substrat-Träger der ersten Be- und/oder Entladestation (2), sowie der Substrate (12) aus der zweiten Substrat-Transporteinrichtung (7) in den Fluid-Behälter (1),
d) lineares Bewegen der beiden Substrat-Transporteinrichtungen (6, 7) in eine Stellung, bei der sich die erste Substrat-Transporteinrichtung (6) über dem Fluid-Behälter (1), und die zweite Substrat-Transporteinrichtung (7) über der zweiten Be- und/oder Entladestation (3) befindet.

13. Verfahren nach Anspruch 12, **dadurch gekennzeichnet, daß** ein Verriegeln der Substrate (12) durch Drehen der Haltestange (20 bzw. 21) der ersten und/oder zweiten Substrat-Transporteinrichtung (6, 7) in die die Substrate (12) haltende, erste Stellung erfolgt, und daß ein Freigeben der Substrate (12) durch Drehen der Haltestangen (20 bzw. 21) der ersten und/oder zweiten Substrat-Transporteinrichtung (6, 7) in die die Substrate (12) freigebende, zweite Stellung erfolgt.

14. Verfahren nach einem der Ansprüche 12 oder 13, **dadurch gekennzeichnet, daß** die Substrate (12) beim Herausheben aus dem Fluid-Behälter (1) in die zweite Substrat-Transporteinrichtung (7) während des Verfahrensschritts a) getrocknet werden.

15. Verfahren nach Anspruch 14, **dadurch gekennzeichnet, daß** während des Heraushebens der Substrate (12) aus dem Fluid-Behälter (1) in die als Haube ausgebildete erste Transportvorrichtung (6) ein Gas in die Haube eingeleitet wird.

16. Verfahren nach einem der Ansprüche 11 bis 14, **dadurch gekennzeichnet, daß** ein Substrat-Träger (10) in der ersten und/oder zweiten Be- und/oder Entladestation (2, 3) nach dem Beladen der ersten und/oder zweiten Substrat-Transporteinrichtung (6, 7) getrocknet wird.

17. Verfahren nach Anspruch 16, **dadurch gekennzeichnet, daß** ein Trocknungsgas auf den Substrat-Träger (10) geblasen wird.

## Claims

1. Device for treating substrates (12), with a fluid container (1) and two substrate transport devices (6 and 7), which are rigidly connected together and able to be brought over the fluid container (1) and which comprise at least one substrate holding device (20 and 21) holding the substrates (12) in a first setting and releasing them in a second, **characterised in that** the two transport devices are constructed as a hood for several substrates and that the substrate transport devices (7 and 6) are linearly movable for alternate positioning of the substrate transport devices (7 and 6) above the fluid container (1).

2. Device according to claim 1, **characterised by** a common device for simultaneous movement of the two substrate transport devices (6, 7).

3. Device according to claim 1 or 2, **characterised by** at least one substrate loading and/or unloading station (2, 3) for loading and/or unloading the transport devices (6, 7).

4. Device according to claim 3, **characterised in that** at least one loading and/or unloading station (2, 3) comprises a device (9) for drying a substrate carrier (10).

5. Device according to one of the preceding claims, **characterised in that** the substrating holding devices (20, 21) comprise at least one rotatable retaining rod.

6. Device according to claim 5, **characterised in that** the retaining rods (20, 21) can be brought by rotation from the first setting holding the substrates (12) to a second setting releasing the substrates.

7. Device according to claim 6, **characterised in that** two opposite walls of the hoods (6, 7) have slots (16 and 17) for the substrates (12).

8. Device according to one of claims 4 to 7, **characterised in that** the holding rods (20, 21) have slots for the substrates (12) in the longitudinal region against which the substrates (12) bear in the first setting holding the substrates.

9. Device according to one of claims 6 to 8, **characterised in that** the hoods (6, 7) are process hoods with inlet openings (13) for at least one fluid.

10. Device according to one of claims 3 to 9, **characterised in that** the loading and/or unloading stations (2, 3) each comprise a respective substrate raising or lowering device (4 or 5) for raising and/or lowering the substrates (12) into the transport device (6, 7) or out of the transport device (6, 7).

11. Method of treating substrates (12) in a fluid container (1) by a device according to one of the preceding claims, wherein the substrates (12) of the substrate transport device (6 or 7) disposed over the fluid container (1) are treated while the other substrate transport device (7 or 6) has substrates (12) unloaded therefrom and/or is loaded with substrates (12).

12. Method of treating substrates (12) in a fluid container (1) by a device according to one of claims 1 to 10, by the following method steps:
a) lifting the substrates (12) out of the fluid container (1) into a first substrate transport device (6) constructed as a hood and simultaneous loading of a second substrate transport device (7) constructed as a hood and as disposed over a second loading and/or unloading station;
b) linear movement of the two substrate transport devices (6, 7) into a setting in which the first substrate transport device is disposed over a first loading and/or unloading station and the second substrate transport device is disposed over the fluid container (19);
c) simultaneous unloading of the substrates from the first substrate transport device (6) into a substrate carrier of the first loading and/or unloading station (2) as well as of the substrates (12) from the second substrate transport device (7) into the fluid container; and
d) linear movement of the two substrate transport devices (6, 7) into a setting in which the first substrate transport device (6) is disposed over the fluid container (1) and the second substrate transport device (7) is disposed over the second loading and/or unloading station (3).

13. Method according to claim 12, **characterised in that** a locking of the substrates (12) by rotation of the retaining rod (20 or 21) of the first and/or second substrate transport device (6, 7) in the first setting retaining the substrates (12) is carried out and that a release of the substrates (12) by rotation of the retaining rods (20 or 21) of the first and/or second substrate transport device (6, 7) into the second setting releasing the substrates (12) is carried out.

14. Method according to one of claims 12 and 13, **characterised in that** the substrates (12) are dried on lifting out from the fluid container (1) into the second substrate transport device (7) during the method step a).

15. Method according to claim 14, **characterised in that** during lifting out of the substrates (12) from the fluid container (1) into the transport device (6) constructed as a hood a gas is conducted into the hood.

16. Method according to one of claims 11 to 14, **characterised in that** a substrate carrier (10) is dried in the first and/or second loading and/or unloading station (2, 3) after loading of the first and/or second substrate transport device (6, 7).

17. Method according to claim 16, **characterised in that** a drying gas is blown onto the substrate carrier (10).

## Revendications

1. Dispositif pour le traitement de substrats (12) avec un récipient de fluide (1) et deux installations de transport de substrats (6 respectivement 7) reliées rigidement l'une à l'autre, pouvant être amenées au-dessus du récipient de fluide (1), qui présentent au moins une installation de retenue de substrats (20 respectivement 21) qui retiennent les substrats (12) dans une première position et les libèrent dans une deuxième, **caractérisé en ce que** les deux installations de transport sont réalisées comme chape pour plusieurs substrats, et **en ce que** les installations de transport de substrats (7 respectivement 6) sont déplaçables linéairement en vue du positionnement alternatif des installations de transport de substrats (7 respectivement 6) au-dessus du récipient de fluide (1).

2. Dispositif selon la revendication 1, **caractérisé par** une installation commune pour le déplacement simultané des deux installations de transport de substrats (6, 7).

3. Dispositif selon la revendication 1 ou 2, **caractérisé par** au moins un poste de chargement et/ou de déchargement de substrats (2, 3) pour charger et/ou décharger les installations de transport (6, 7).

4. Dispositif selon la revendication 3, **caractérisé en ce qu'**au moins un poste de chargement et/ou de déchargement (2, 3) présente une installation (9) pour le séchage d'un support de substrats (10).

5. Dispositif selon l'une des revendications précédentes, **caractérisé en ce que** les installations de retenue de substrats (20, 21) comprennent au moins une tige de retenue tournante.

6. Dispositif selon la revendication 5, **caractérisé en ce que** les tiges de retenue (20, 21) peuvent être amenées par rotation de la première position retenant les substrats (12) dans une deuxième position libérant les substrats (12).

7. Dispositif selon la revendication 6, **caractérisé en ce que** deux parois opposées des chapes (6, 7) présentent des fentes (16 respectivement 17) pour les substrats (12).

8. Dispositif selon l'une des revendications 4 à 7, **caractérisé en ce que** les tiges de retenue (20, 21) présentent dans la zone longitudinale, à laquelle les substrats (12) s'appliquent dans la première position retenant les substrats, des fentes pour les substrats (12).

9. Dispositif selon l'une des revendications 6 à 8, **caractérisé en ce que** les chapes (6, 7) sont des chapes de traitement avec des ouvertures d'entrée (13) pour au moins un fluide.

10. Dispositif selon l'une des revendications 3 à 9, **caractérisé en ce que** les postes de chargement et/ou de déchargement (2, 3) présentent chacun un dispositif de relevage respectivement d'abaissement (4 respectivement 5) des substrats pour relever et/ou abaisser les substrats (12) dans l'installation de transport (6, 7) respectivement de l'installation de transport (6, 7).

11. Procédé de traitement de substrats (12) dans un récipient de fluide (1) avec un dispositif selon l'une des revendications précédentes, où les substrats (12) de l'installation de transport de substrats (6 respectivement 7) se trouvant au-dessus du récipient de fluide (1) sont traités, tandis que les substrats (12) sont déchargés de et/ou les substrats (6, 7) sont chargés dans l'autre installation de transport de substrats.

12. Procédé pour le traitement de substrats (12) dans un récipient de fluide (1) avec un dispositif selon l'une des revendications 1 à 10, comprenant les étapes de procédé consistant à :
a) sortir les substrats (12) du récipient de fluide (1) dans une première installation de transport de substrats (6) réalisée comme chape et charger simultanément une seconde installation de transport de substrats (7) réalisée comme chape, qui se trouve au-dessus d'un second poste de chargement et/ou de déchargement ;
b) déplacer linéairement les deux installations de transport de substrats (6, 7) dans une position, dans laquelle la première installation de transport de substrats se trouve au-dessus d'un premier poste de chargement et/ou de déchargement, et la seconde installation de transport de substrats se trouve au-dessus du récipient de fluide (19) ;
c) décharger simultanément les substrats de la première installation de transport de substrats (6) dans un support de substrats du premier poste de chargement et/ou de déchargement (2), et des substrats (12) de la seconde installation de transport de substrats (7) dans le récipient de fluide (1),
d) déplacer linéairement les deux installations de transport de substrats (6, 7) dans une position dans laquelle la première installation de transport de substrats (6) se trouve au-dessus du récipient de fluide (1), et la seconde installation de transport de substrats (7) au-dessus du deuxième poste de chargement et/ou de déchargement (3).

13. Procédé selon la revendication 12, **caractérisé en ce qu'**un verrouillage des substrats (12) a lieu par une rotation de la tige de retenue (20 respectivement 21) de la première et/ou seconde installation de transport de substrats (6, 7) dans la première position retenant les substrats (12), et **en ce qu'**une libération des substrats (12) a lieu par une rotation des tiges de retenue (20 respectivement 21) de la première et/ou seconde installation de transport de substrats (6, 7) dans la seconde position libérant les substrats (12).

14. Procédé selon l'une des revendications 12 ou 13, **caractérisé en ce que** les substrats (12) lors de la sortie du récipient de fluide (1) dans la seconde installation de transport de substrats (7), sont séchés pendant l'étape de procédé a).

15. Procédé selon la revendication 14, **caractérisé en ce que** pendant la sortie des substrats (12) du récipient de fluide (1) dans le premier dispositif de transport (6) réalisé comme chape, un gaz est introduit dans la chape.

16. Procédé selon l'une des revendications 11 à 14, **caractérisé en ce qu'**un support de substrat (10) est séché dans le premier et/ou deuxième poste de chargement et/ou de déchargement (2, 3) après le chargement de la première et/ou deuxième installation de transport de substrats (6, 7).

17. Procédé selon la revendication 16, **caractérisé en ce qu'**un gaz de séchage est soufflé sur le support de substrat (10).
